# EUROPEAN PATENT APPLICATION

(11) **EP 4 779 821 A1**
(43) Date of publication of application: **22.07.2026**
(21) Application number: 24869758.3
(22) Date of filing: 20.05.2024
(51) Int. Cl.: H01S 5/026, G02F 1/025

(54) **TUNABLE LASER, PHOTOELECTRIC CONVERSION MODULE AND COMMUNICATION SYSTEM**

(30) Priority: 26.09.2023 CN 202311271559
(71) Applicant: HUAWEI TECHNOLOGIES CO., LTD., Shenzhen 518129 (CN)
(72) Inventor: LIU, Gonghai, Shenzhen, Guangdong 518129 (CN); SHAO, Haifeng, Shenzhen, Guangdong 518129 (CN)
(74) Representative: Körber, Martin Hans
(86) International application number: PCT/CN2024/094142
(87) International publication number: WO 2025/066192

(57) **Abstract**

A tunable laser (211), a photoelectric conversion module (112), and a communication system (101) are provided, to suppress a concentration of photogenerated carriers in the tunable laser (211), so as to effectively suppress phase noise. The tunable laser (211) includes a gain module (301), a first waveguide module (302), a gain electrode (314), a first waveguide electrode (324), and a first heating element (325). The gain electrode (314) applies a current to the gain module (301), the gain module (301) emits an optical signal based on the current, the first heating element (325) applies first heat to the first waveguide module (302), and the first waveguide module (302) tunes a wavelength of the optical signal under action of the first heat, so that the tunable laser (211) emits an optical signal tuned by the first waveguide module (302). The first waveguide electrode (324) applies a first reverse bias voltage to a first PN junction, and the first reverse bias voltage is used to enable the first PN junction to be in a reverse cut-off state.

## Description

This application claims priority to Chinese Patent Application No. 202311271559.3, filed with the China National Intellectual Property Administration on September 26, 2023 and entitled "TUNABLE LASER, PHOTOELECTRIC CONVERSION MODULE, AND COMMUNICATION SYSTEM", which is incorporated herein by reference in its entirety.

### TECHNICAL FIELD

Embodiments of this application relate to the optical communication field, and in particular, to a tunable laser, a photoelectric conversion module, and a communication system.

### BACKGROUND

In the optical communication field, a tunable laser (tunable laser, TL) is a laser whose output wavelength can be tuned within a specific range. The tunable laser is mainly applied to a large-capacity wavelength division multiplexing transmission system.

A distributed Bragg reflector (distributed Bragg reflector, DBR) laser includes an optical resonance cavity. The DBR laser heats the optical resonance cavity in a thermal tuning manner, to change a refractive index of the optical resonance cavity, and further tune a wavelength of an optical signal emitted by the DBR laser.

However, the thermal tuning manner of the DBR laser generates unstable photogenerated carriers, and the photogenerated carriers increase phase noise of the DBR laser.

### SUMMARY

Embodiments of this application provide a tunable laser, a photoelectric conversion module, and a communication system, to suppress a concentration of photogenerated carriers in the tunable laser, so as to effectively suppress phase noise.

According to a first aspect, an embodiment of this application provides a tunable laser, including a gain module, a first waveguide module, a gain electrode, a first waveguide electrode, and a first heating element, where the gain module is connected to the gain electrode, the first waveguide electrode and the first heating element are separately connected to the first waveguide module, and the first waveguide module includes a first PN junction; the gain electrode is configured to apply a current to the gain module, the gain module is configured to emit an optical signal based on the current, the first heating element is configured to apply first heat to the first waveguide module, and the first waveguide module is configured to tune a wavelength of the optical signal under action of the first heat, so that the tunable laser emits an optical signal tuned by the first waveguide module; and the first waveguide electrode is configured to apply a first reverse bias voltage to the first PN junction, the first reverse bias voltage is used to enable the first PN junction to be in a reverse cut-off state, and the first PN junction in the reverse cut-off state can enable first photogenerated carriers generated at the first PN junction to flow out of the first waveguide module.

According to this aspect, the first PN junction in the reverse cut-off state can enable the first photogenerated carriers generated at the first PN junction to flow out of the first waveguide module, to reduce a concentration of first photogenerated carriers in the first waveguide module, thereby effectively reducing a probability of random recombination of the first photogenerated carriers in the first waveguide module. This suppresses the random recombination of the first photogenerated carriers in the first waveguide module, and then effectively suppresses phase noise of the first waveguide module.

Based on the first aspect, in an optional implementation, the tunable laser further includes a second waveguide module, the first waveguide module and the second waveguide module form an optical resonance cavity used to tune the wavelength of the optical signal, and the gain module is located in the optical resonance cavity.

In this implementation, the optical resonance cavity of the tunable laser can not only tune the wavelength, but also effectively suppress a concentration of photogenerated carriers generated by the optical resonance cavity, thereby effectively suppressing phase noise of the optical resonance cavity.

According to the first aspect, in an optional implementation, the tunable laser further includes a second heating element, and the second heating element is connected to the second waveguide module; and the second heating element is configured to apply second heat to the second waveguide module, and the second waveguide module is configured to tune the wavelength of the optical signal under action of the second heat.

In this implementation, the second heating element can change a refractive index of the second waveguide module, so that the second waveguide module tunes the wavelength.

According to the first aspect, in an optional implementation, the tunable laser further includes a second waveguide electrode, the second waveguide electrode is connected to the second waveguide module, and the second waveguide module includes a second PN junction; and the second waveguide electrode is configured to apply a second reverse bias voltage to the second PN junction, the second reverse bias voltage is used to enable the second PN junction to be in a reverse cut-off state, and the second PN junction in the reverse cut-off state is used to enable second photogenerated carriers generated at the second PN junction to flow out of the second waveguide module.

In this implementation, the second PN junction in the reverse cut-off state can enable the second photogenerated carriers generated at the second PN junction to flow out of the second waveguide module, to reduce a concentration of second photogenerated carriers in the second waveguide module, thereby effectively reducing a probability of random recombination of the second photogenerated carriers in the second waveguide module. This suppresses the random recombination of the second photogenerated carriers in the second waveguide module, and then effectively suppresses phase noise of the second waveguide module.

According to the first aspect, in an optional implementation, the tunable laser further includes a third waveguide module and a third heating element, the third heating element is connected to the third waveguide module, and the third waveguide module is located in the optical resonance cavity; and the third heating element is configured to apply third heat to the third waveguide module, and the third waveguide module is configured to tune the wavelength of the optical signal under action of the third heat.

In this implementation, the third waveguide module located in the optical resonance cavity is used to precisely turn the wavelength.

According to the first aspect, in an optional implementation, the tunable laser further includes a third waveguide electrode, the third waveguide electrode is connected to the third waveguide module, and the third waveguide module includes a third PN junction; and the third waveguide electrode is configured to apply a third reverse bias voltage to the third PN junction, the third reverse bias voltage is used to enable the third PN junction to be in a reverse cut-off state, and the third PN junction in the reverse cut-off state is used to enable third photogenerated carriers generated at the third PN junction to flow out of the third waveguide module.

In this implementation, the third PN junction in the reverse cut-off state can enable the third photogenerated carriers generated at the third PN junction to flow out of the third waveguide module, to effectively reduce a concentration of third photogenerated carriers in the third waveguide module, thereby effectively reducing a probability of random recombination of the third photogenerated carriers in the third waveguide module. This suppresses the random recombination of the third photogenerated carriers in the third waveguide module, and effectively suppresses phase noise of the third waveguide module.

According to the first aspect, in an optional implementation, the tunable laser includes a fourth waveguide module and a fifth waveguide module, the fourth waveguide module and the fifth waveguide module form an optical resonance cavity used to tune the wavelength of the optical signal, and the gain module and the first waveguide module are located in the optical resonance cavity.

In this implementation, the first waveguide module located in the optical resonance cavity is used to precisely turn the wavelength, and phase noise can be effectively suppressed.

According to the first aspect, in an optional implementation, the first PN junction is located inside the first waveguide module, or the first PN junction is located on a surface of the first waveguide module.

In this implementation, regardless of whether the first PN junction is located inside the first waveguide module or on the surface of the first waveguide module, a concentration of first photogenerated carriers in the first PN junction can be effectively suppressed, to effectively suppress phase noise of the tunable laser.

According to the first aspect, in an optional implementation, a rate at which the first photogenerated carriers flow out of the first waveguide module is positively correlated with a magnitude of the first reverse bias voltage.

In this implementation, the rate at which the first photogenerated carriers flow out of the first waveguide module can be correspondingly adjusted by adjusting the magnitude of the first reverse bias voltage, to ensure that the first photogenerated carriers can flow out of the tunable laser in a timely manner, so as to effectively suppress the phase noise.

According to the first aspect, in an optional implementation, the first waveguide electrode is located between the first waveguide module and the first heating element, or the first heating element is located between the first waveguide electrode and the first waveguide module, the first heating element has a via, and the first waveguide electrode is connected to the first waveguide module through the via.

In this implementation, it is ensured that the first heating element can apply the first heat to the first waveguide module to tune the wavelength of the optical signal, and it is ensured that the first waveguide electrode can apply the first reverse bias voltage to the first waveguide module, thereby effectively suppressing the phase noise.

According to a second aspect, an embodiment of this application provides a photoelectric conversion module, including a modulator, an output optical fiber, and the tunable laser according to any one of the first aspect, where the modulator is separately connected to the tunable laser and the output optical fiber; the modulator is configured to: receive a first service electrical signal, and receive the tuned optical signal from the tunable laser; and the modulator is further configured to: modulate the first service electrical signal onto the tuned optical signal to obtain a first service optical signal, and emit the first service optical signal through the output optical fiber. For descriptions of the tunable laser and beneficial effect thereof in this aspect, refer to the first aspect. Details are not described again.

According to a third aspect, an embodiment of this application provides a photoelectric conversion module, including a demodulator, an input optical fiber, and the tunable laser according to any one of the first aspect, where the demodulator is separately connected to the tunable laser and the input optical fiber; the demodulator is configured to: receive a second service optical signal from the input optical fiber, and receive the tuned optical signal from the tunable laser; and the demodulator is further configured to perform coherent demodulation on the second service optical signal based on the tuned optical signal to obtain a second service electrical signal. For descriptions of the tunable laser and beneficial effect thereof in this aspect, refer to the first aspect. Details are not described again.

According to a fourth aspect, an embodiment of this application provides a communication system, including a device and the photoelectric conversion module according to the second aspect, where the device includes a processing chip and a connector, the processing chip is connected to the photoelectric conversion module via the connector, and the processing chip is configured to send the first service electrical signal to the photoelectric conversion module.

According to a fifth aspect, an embodiment of this application provides a communication system, including a device and the photoelectric conversion module according to the third aspect, where the device includes a processing chip and a connector, the processing chip is connected to the photoelectric conversion module via the connector, and the processing chip is configured to receive the second service electrical signal sent by the photoelectric conversion module.

According to a sixth aspect, an embodiment of this application provides an optical network, including a first communication system and a second communication system. For descriptions of the first communication system and the second communication system, refer to the fourth aspect and the fifth aspect. Details are not described again.

### BRIEF DESCRIPTION OF DRAWINGS

FIG. 1 is an example diagram of a structure of an optical network according to this application;
FIG. 2a is an example diagram of a structure of a first communication system according to this application;
FIG. 2b is an example diagram of a structure of a second communication system according to this application;
FIG. 3 is an example diagram of a structure of a first embodiment of a tunable laser according to this application;
FIG. 4 is a side-view example diagram of a structure of a first embodiment of the tunable laser shown in FIG. 3;
FIG. 5 is an example diagram of comparison between a phase noise curve of a tunable laser and a phase noise curve of an existing DBR laser according to this application;
FIG. 6a is an example diagram of a structure of a second embodiment of a tunable laser according to this application;
FIG. 6b is a side-view example diagram of a structure of an embodiment of the tunable laser shown in FIG. 6a;
FIG. 7 is a side-view example diagram of a structure of a second embodiment of the tunable laser shown in FIG. 3;
FIG. 8 is an example diagram of a structure of a second embodiment of a tunable laser according to this application;
FIG. 9 is a cross-sectional example diagram of a structure of the tunable laser shown in FIG. 8;
FIG. 10 is an example diagram of a structure of a third embodiment of a tunable laser according to this application;
FIG. 11 is an example diagram of a structure of a fourth embodiment of a tunable laser according to this application;
FIG. 12 is an example diagram of a structure of a fifth embodiment of a tunable laser according to this application; and
FIG. 13 is an example diagram of a structure of a sixth embodiment of a tunable laser according to this application.

### DESCRIPTION OF EMBODIMENTS

The following clearly and completely describes the technical solutions in embodiments of this application with reference to accompanying drawings in embodiments of this application. It is clear that the described embodiments are merely a part but not all of embodiments of this application. All other embodiments obtained by a person skilled in the art based on embodiments of this application without creative efforts shall fall within the protection scope of this application.

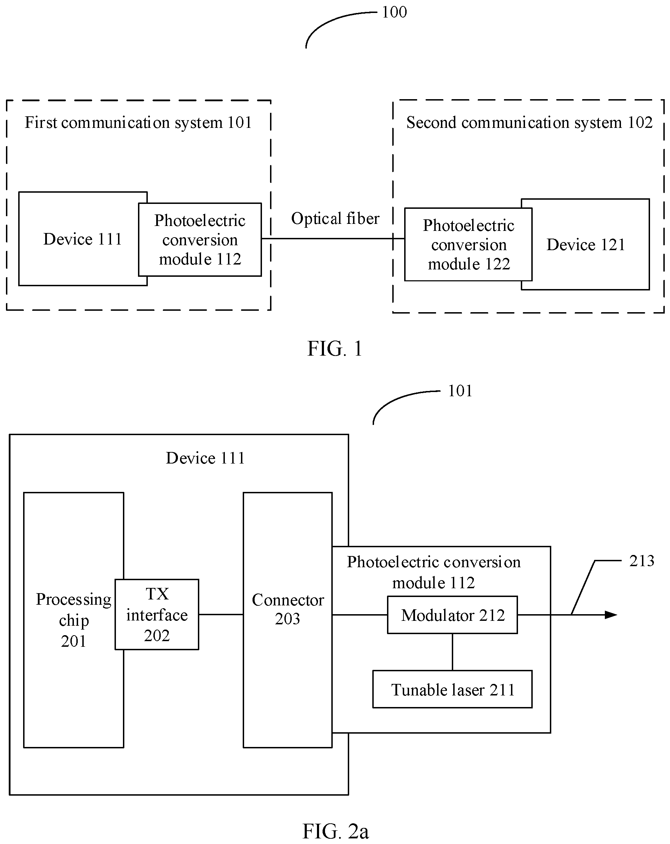

FIG. 1 is an example diagram of a structure of an optical network according to this application. An optical network 100 includes a first communication system 101 and a second communication system 102. The first communication system 101 and the second communication system 102 are connected to each other through an optical fiber. A quantity of communication systems included in the optical network 100 is not limited in this example. For example, the first communication system 101 may be connected to a plurality of second communication systems 102 through an optical splitter. A networking type of the optical network is not limited in this example. For example, the optical network may use ring networking, star networking, or the like. A type of a network to which the optical network 100 is applied is not limited in this example. For example, if the optical network 100 shown in this example is applied to a passive optical network (passive optical network, PON), one of the first communication system 101 and the second communication system 102 may be an optical network unit (optical network unit, ONU) or an optical network terminal (optical network terminal, ONT), and the other of the first communication system 101 and the second communication system 102 may be an optical line terminal (optical line terminal, OLT). If the optical network 100 is applied to an optical transport network (optical transport network, OTN), both the first communication system 101 and the second communication system 102 may be OTN devices. The optical network 100 shown in this example may be further applied to a data center network (data center network, DCN), a metropolitan area network, or the like. This is not specifically limited. The first communication system 101 is used as an example. A device type of the first communication system 101 is not limited in this example. For example, the first communication system 101 may be an optical transmission device, an optical access device, a router, a switch, a wireless base station, a wireless remote access device, a radio baseband signal processing device, or the like, or may be a computing server (usually briefly referred to as a server), a high-performance computer (high performance computer, HPC), a storage server, a memory resource pool, or the like. A type of the first communication system 101 is not limited in this example, provided that the first communication system 101 has an electrical-to-optical conversion function and has an optical interface that can be connected to the optical fiber. For a description of a type of the second communication system 102, refer to the description of the first communication system 101. Details are not described.

FIG. 2a is an example diagram of a structure of a first communication system according to this application. The first communication system 101 includes a device 111 and one or more photoelectric conversion modules 112. The photoelectric conversion module 112 may also be referred to as an optical transceiver module, an optical module, or the like. A quantity of devices 111 included in the first communication system 101 is not limited in this example. The device 111 and the first communication system 101 are an integrated device, or the device 111 is an independent pluggable board. A quantity of photoelectric conversion modules 112 included in the first communication system 101 is not limited in this example. The photoelectric conversion module 112 may be integrated with the device 111, may be pluggable on a board of the device 111, or the like. This is not specifically limited. Specifically, a processing chip 201 and a connector 203 has been encapsulated into the device 111. The processing chip 201 may be one or more chips or one or more integrated circuits. For another example, the processing chip 201 may be one or more optical digital signal processors (optical digital signal processors, oDSPs), a field-programmable gate array (field-programmable gate array, FPGA), an application-specific integrated chip (application-specific integrated circuit, ASIC), a system on chip (system on chip, SoC), a central processing unit (central processing unit, CPU), a network processor (network processor, NP), a microprocessor unit (microcontroller unit, MCU), a programmable processor (programmable logic device, PLD), a network adapter chip, a storage interface chip, another integrated chip, or any combination of the foregoing chips or processing modules, or the like. Details are not described. The processing chip 201 has a transmit (transport, TX) interface 202, and the TX interface 202 is connected to the connector 203. The connector 203 is configured to provide an electrical interface, and the electrical interface implements a pluggable connection to the photoelectric conversion module 112. The photoelectric conversion module 112 includes a modulator 212 connected to the connector 203 and a tunable laser 211 connected to the modulator 212. The tunable laser 211 tunes a wavelength of an emitted optical signal, and sends the tuned optical signal to the modulator 212. The modulator 212 receives a first service electrical signal from the device 111, and modulates the first service electrical signal onto the tuned optical signal to obtain a first service optical signal. The modulator 212 is connected to an output optical fiber 213. In this case, the modulator 212 emits the first service optical signal through the output optical fiber 213.

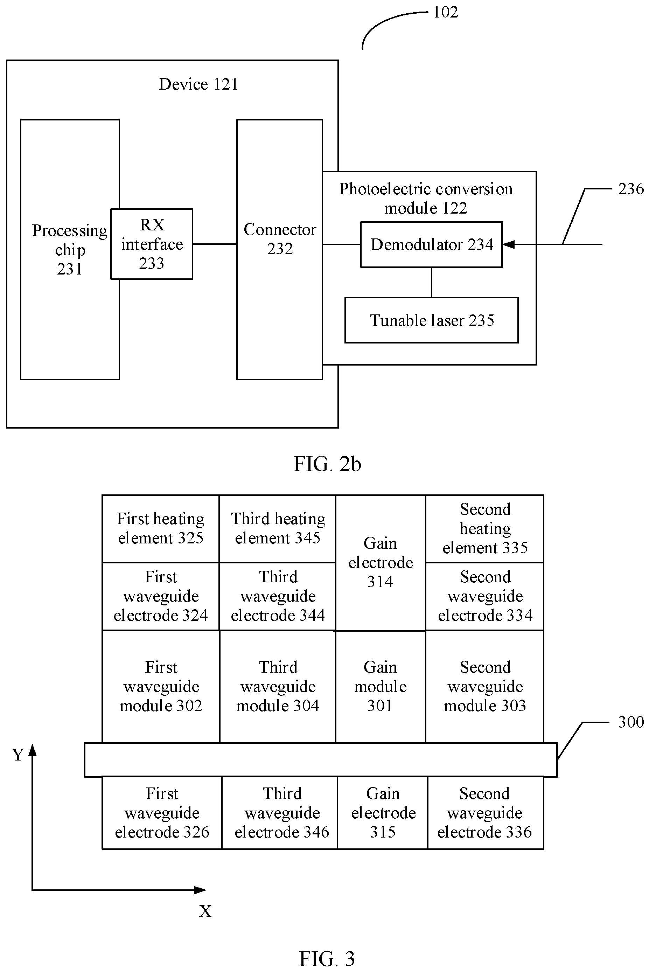

FIG. 2b is an example diagram of a structure of a second communication system according to this application. The second communication system 102 includes a device 121 and one or more photoelectric conversion modules 122. A quantity of devices 121 included in the second communication system 102 is not limited in this example. For a description of the device 121, refer to the description of the device 111 shown in FIG. 2a. Details are not described again. A quantity of photoelectric conversion modules 122 included in the second communication system 102 is not limited in this example. The photoelectric conversion module 122 may be integrated with the device 121, may be pluggable on a board of the device 121, or the like. This is not specifically limited. Specifically, a processing chip 231 and a connector 232 has been encapsulated into the device 121. The processing chip 201 has a receive (receive, RX) interface 233, and the RX interface 233 is connected to the connector 232. The connector 232 is configured to provide an electrical interface, and the electrical interface implements a pluggable connection to the photoelectric conversion module 122. The photoelectric conversion module 122 includes a demodulator 234 connected to the connector 232 and a tunable laser 235 connected to the demodulator 234. The demodulator 234 is connected to an input optical fiber 236, and receives a second service optical signal through the input optical fiber 236. The demodulator 234 receives a tuned optical signal from the tunable laser 235. The demodulator 234 performs coherent demodulation on the second service optical signal based on the tuned optical signal to obtain a second service electrical signal. The demodulator 234 sends the second service electrical signal to the processing chip 231 through the connector 232 and the RX interface 233.

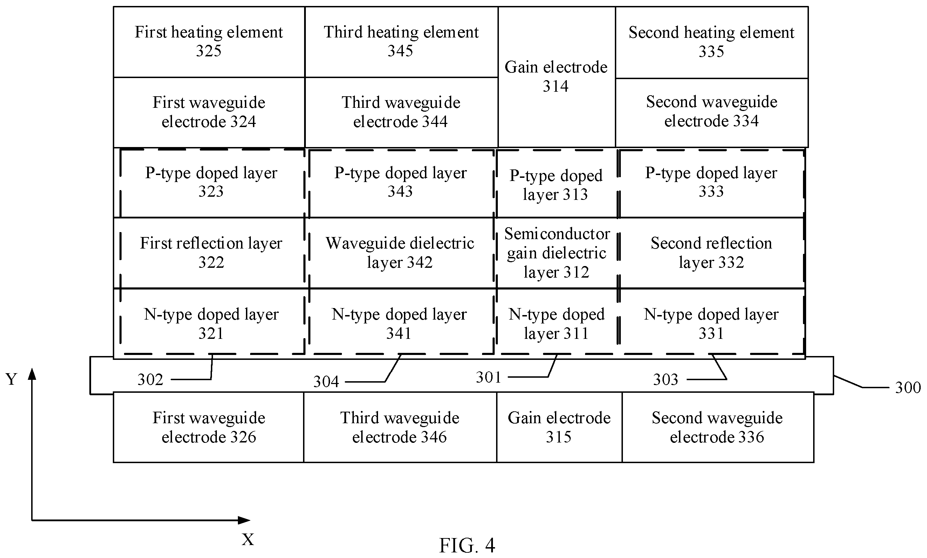

FIG. 3 is an example diagram of a structure of a first embodiment of a tunable laser according to this application. FIG. 4 is a side-view example diagram of a structure of a first embodiment of the tunable laser shown in FIG. 3. FIG. 4 is a side-view example diagram of the structure of the tunable laser in a plane XY. The plane XY includes a direction X and a direction Y. The direction X is an emergent direction of a tuned optical signal, and the direction Y is a direction perpendicular to a substrate surface of the tunable laser. In this embodiment, an example in which the direction X is perpendicular to the direction Y is used. In another example, there may alternatively be a specific included angle between the direction X and the direction Y. This is not specifically limited. In this embodiment, an example in which a type of the tunable laser is a DBR laser is used. It should be noted that a type of the tunable laser is not limited in this embodiment. For example, the type of the tunable laser may alternatively be a vertical-cavity surface-emitting laser (vertical-cavity surface-emitting Laser, VCSEL), a modulated grating y-branch laser (modulated grating y-branch, MG-Y laser), a multi-channel interference laser (multi-channel interference, MCI laser), a V-coupled cavity laser (V-cavity laser), or a chirped sampled grating-distributed reflector laser (chirped sampled grating-distributed reflector laser, CSG-DR laser). The tunable laser shown in this embodiment is configured to emit a tuned optical signal, and optical power of the tuned optical signal is amplified and a wavelength of the tuned optical signal is tuned. Specifically, the tunable laser includes a substrate 300, and a first waveguide module 302, a third waveguide module 304, a gain module 301, and a second waveguide module 303 are sequentially arranged on a surface of the substrate 300 in the direction X. In this embodiment, an example in which the third waveguide module 304 is located between the first waveguide module 302 and the gain module 301 is used. In another example, the third waveguide module 304 may alternatively be located between the gain module 301 and the second waveguide module 303. In this embodiment, an example in which the first waveguide module 302, the third waveguide module 304, the gain module 301, and the second waveguide module 303 are monolithically integrated in a photonic integration manner is used. The tunable laser obtained through monolithic integration can reduce a spectral linewidth corresponding to an output tuned optical signal, and improve bandwidth utilization.

The substrate 300 may be an indium phosphide (InP) substrate, an indium gallium arsenide (InGaAs) substrate, a GaAs substrate, an indium gallium aluminum arsenide (InGaAlAs) substrate, a gallium arsenide aluminum antimonide (InGaAlAsSb) substrate, an aluminum gallium arsenide (ALGaAs) substrate, a gallium nitride (GaN) substrate, or the like. This is not specifically limited in this embodiment. The gain module 301 includes an N-type doped layer 311 located on the surface of the substrate 300. The N-type doped layer 311 may be N-type doped InGaAsP, InP, or GaAs. In this embodiment, an example in which the N-type doped layer 311 is N-type doped InP is used. Therefore, the N-type doped layer 311 is an N-InP layer. For example, the N-type doped layer 311 is obtained by injecting N-type ions of a semiconductor material into InP. A surface of the N-type doped layer 311 includes a semiconductor gain dielectric layer 312, and the semiconductor gain dielectric layer 312 is made of a semiconductor gain dielectric material and is configured to amplify power of an optical signal. For example, in this embodiment, the semiconductor gain dielectric material is a multiple quantum well (multiple quantum well, MQW). The gain module 301 further includes a P-type doped layer 313 located on a surface of the semiconductor gain dielectric layer 312. The P-type doped layer 313 may be P-type doped InGaAsP, InP, or GaAs. In this embodiment, an example in which the P-type doped layer 313 is P-type doped InP is used. Therefore, the P-type doped layer 313 is a P-InP layer. For example, the P-type doped layer 313 is obtained by injecting P-type ions of a semiconductor material into InP. The N-type doped layer 311 and the P-type doped layer 313 form a first PN junction. Specifically, in this embodiment, an example in which the first PN junction is of a PIN diode (positive intrinsic negative diode, PIN diode) structure is used. The tunable laser includes two gain electrodes connected to the gain module 301. The two gain electrodes specifically include a gain electrode 314 and a gain electrode 315. It may be understood that the gain electrode 314 and the gain electrode 315 can supply power to the gain module 301 and form a circuit loop. The gain electrode 314 is located on a surface of the P-type doped layer 313. In the direction Y, the gain electrode 315 and the gain module 301 are located on two surfaces of the substrate 300, and the gain electrode 315 is connected to the N-type doped layer 311 through the substrate 300 and 6. The description of a position of the gain electrode 315 in this embodiment is an optional example, and is not limited. For example, the gain electrode 315 is located between the surface of the substrate 300 and the N-type doped layer 311. The gain electrode 314 is configured to apply a current to the gain module 301, and the gain module 301 is configured to emit an optical signal based on the current. That is, the gain module 301 generates an optical signal under excitation of the current. Specifically, when the current passes through the P-type doped layer 313 and the N-type doped layer 311, electrons flow from the N-type doped layer 311 to the P-type doped layer 313, and holes flow from the P-type doped layer 313 to the N-type doped layer 311. Population inversion is formed at the first PN junction, the electrons and the holes are recombined to generate an optical signal, and the optical signal is emitted. Refer to FIG. 2a and FIG. 2b. The gain electrode 314 is connected to an electrical port of the processing chip, and the processing chip is configured to send a current or a voltage to the gain electrode 314, so that the gain electrode 314 applies the current to the gain module 301. Optionally, if the photoelectric conversion module includes a processor, the gain electrode 314 is connected to an electrical port of the processor. For a description of a type of the processor of the photoelectric conversion module, refer to the description of the type of the processor of the processing chip. Details are not described again.

The first waveguide module 302 includes an N-type doped layer 321 located on the surface of the substrate 300. For a description of the N-type doped layer 321, refer to the description of the N-type doped layer 311 of the gain module 301. Details are not described again. The first waveguide module 302 further includes a first reflection layer 322 located on a surface of the N-type doped layer 321. A structure of the first reflection layer 322 shown in this embodiment may be a grating, a microring, or a waveguide. The first reflection layer 322 may be a non-doped indium gallium arsenide phosphide (InGaAsP) layer, for example, an intrinsic InGaAsP layer, namely, an i-InGaAsP layer. The first waveguide module 302 further includes a P-type doped layer 323 located on a surface of the first reflection layer 322. For a description of the P-type doped layer 323, refer to the description of the P-type doped layer 313 of the gain module 301. Details are not described again. The second waveguide module 303 includes an N-type doped layer 331, a second reflection layer 332, and a P-type doped layer 333. For descriptions of the N-type doped layer 331, the second reflection layer 332, and the P-type doped layer 333 included in the second waveguide module 303, refer to the descriptions of the N-type doped layer 321, the first reflection layer 322, and the P-type doped layer 323 of the first waveguide module 302. Details are not described again. The first reflection layer 322 and the second reflection layer 332 shown in this embodiment form an optical resonance cavity. Optionally, the first reflection layer 322 and the second reflection layer 332 may form a periodic tuning structure similar to a Fabry-perot (fabry-perot, F-P) standard, which is equivalent to integrating an FP cavity in the tunable laser. It should be noted that a wavelength range that can be tuned by the optical resonance cavity is not limited in this embodiment. The optical resonance cavity formed by the first reflection layer 322 and the second reflection layer 332 is configured to periodically tune the optical signal emitted by the gain module 301. Specifically, the optical signal emitted by the gain module 301 is reflected between the first reflection layer 322 and the second reflection layer 332 for a plurality of times, to form interference between reflected light, so as to implement periodic tuning. For example, if a wavelength that is of the emitted optical signal and that is expected by the tunable laser is a target wavelength, optical power of the target wavelength transmitted in the optical resonance cavity obtains a maximum gain, so that the target wavelength generates peak optical power. It may be understood that the optical resonance cavity formed by the first reflection layer 322 and the second reflection layer 332 reflects the optical signal emitted by the gain module for a plurality of times, so that the optical power of the target wavelength is enhanced. The optical signal having the target wavelength is transmitted out of the second waveguide module 303, and then emitted from the tunable laser. In addition, optical power of other optical signals gradually decreases until the optical power is basically close to zero.

The tunable laser shown in this embodiment further includes a first heating element 325 and two first waveguide electrodes. Specifically, the two first waveguide electrodes include a first waveguide electrode 324 and a first waveguide electrode 326. The first waveguide electrode 324 is located on a surface of the P-type doped layer 323, and the first heating element 325 is located on a surface of the first waveguide electrode 324. It should be noted that, the description of positions of the first heating element 325 and the first waveguide electrode 324 in this embodiment is an optional example, and is not limited. For example, the first heating element 325 is located on the surface of the P-type doped layer 323, and the first waveguide electrode 324 is located on a surface of the first heating element 325. In this example, the first heating element 325 has a via, and the first waveguide electrode 324 is connected to the P-type doped layer 323 through the via. In the direction Y, the first waveguide electrode 326 and the N-type doped layer 321 are located on the two surfaces of the substrate 300, and the first waveguide electrode 326 is connected to the N-type doped layer 321 through the substrate 300. The description of a position of the first waveguide electrode 326 in this embodiment is an optional example, and is not limited. For example, the first waveguide electrode 326 is located between the surface of the substrate 300 and the N-type doped layer 321. The tunable laser shown in this embodiment can tune a magnitude of the target wavelength. Specifically, in a heating tuning manner, the first heating element 325 can apply first heat to the first waveguide module 302, and the first waveguide module 302 is configured to tune the target wavelength under action of the first heat. The first heating element 325 may be located on an electromagnetic heating layer or a heating resistor sheet on the surface of the first waveguide electrode 324. In this embodiment, an example in which the first heating element 325 is a heating resistor sheet is used. This is not specifically limited. As shown in FIG. 2a and FIG. 2b, the first heating element 325 is connected to an electrical port of the processing chip, the processing chip sends a current or a voltage to the first heating element 325, and the first heating element 325 applies the first heat to the first waveguide module 302 based on the current or the voltage. Optionally, if the photoelectric conversion module 112 includes a processor, the first heating element 325 is connected to an electrical port of the processor. Under the action of the first heat, a refractive index of the first reflection layer 322 of the first waveguide module 302 changes, and the magnitude of the target wavelength is changed.

In this embodiment, the optical signal emitted by the gain module 301 enters the first waveguide module 302. When the first waveguide module 302 is excited by the optical signal, electrons are excited to migrate to a conduction band, to form conduction band electrons and valence band holes, which are generally referred to as photogenerated carriers. The following uses an example in which the photogenerated carriers generated by the first waveguide module 302 are referred to as first photogenerated carriers. A concentration of the first photogenerated carriers diffuses in the first waveguide module 302. Because lives of the first photogenerated carriers are short, phase noise of the tunable laser is increased at a low frequency (that is, near megahertz). In addition, the first photogenerated carriers in the first waveguide module 302 further undergo random recombination. Specifically, new first photogenerated carriers are continuously generated in the first waveguide module 302, and the first photogenerated carriers generated by the first waveguide module 302 at different times are recombined. The recombination causes energy transition of the first photogenerated carriers. A state of the first photogenerated carriers with high energy is unstable, and the unstable first photogenerated carriers are represented as unstable and random noise in the tunable laser.

The tunable laser shown in this embodiment can reduce the concentration of the first photogenerated carriers in the first waveguide module 302, thereby effectively reducing a probability of random recombination of the first photogenerated carriers in the first waveguide module 302. This achieves the purpose of suppressing the random recombination of the first photogenerated carriers in the first waveguide module 302, and effectively suppresses phase noise of the first waveguide module 302. To achieve this purpose, the first waveguide electrode of the tunable laser can apply a first reverse bias voltage to the first waveguide module 302. The first reverse bias voltage applies a reverse potential difference to the first PN junction, and the reverse potential difference can exhaust the first photogenerated carriers in the first waveguide module 302, thereby reducing the concentration of the first photogenerated carriers in the first waveguide module 302. Specifically, when the first photogenerated carriers flow between first PN junctions in the first waveguide module 302, and the first waveguide electrode applies a reverse potential difference to the first PN junctions, the first PN junctions are in a reverse cut-off state, and the first photogenerated carriers are exhausted at the first PN junctions in the reverse cut-off state. Refer to FIG. 3. The first waveguide electrode 324 is connected to the P-type doped layer 323. In this case, the first waveguide electrode 324 is connected to an anode (namely, the P-type doped layer 323) of the first PN junction. The first waveguide electrode 326 is connected to the N-type doped layer 321. In this case, the first waveguide electrode 326 is connected to a cathode (namely, the N-type doped layer 321) of the first PN junction. The first waveguide electrode 324 and the first waveguide electrode 326 apply the first reverse bias voltage to the first PN junction. It may be understood that the first reverse bias voltage means that a polarity of a voltage applied between the first waveguide electrode 324 and the first waveguide electrode 326 is opposite to a polarity of the first PN junction. The first PN junction in the reverse cut-off state enables the first photogenerated carriers in the first waveguide module 302 to flow out of the first waveguide module 302, and the first photogenerated carriers flowing out of the first waveguide module 302 flow to the ground through a ground end of the first waveguide electrode. A rate at which the first photogenerated carriers flow out of the first waveguide module 302 is positively correlated with a magnitude of the first reverse bias voltage applied by the first waveguide electrode. In other words, a higher first reverse bias voltage applied to the first PN junction indicates a faster rate at which the first photogenerated carriers flow out of the first waveguide module 302, so that the concentration of the first photogenerated carriers in the first waveguide module 302 is lower.

Optionally, the tunable laser shown in this embodiment further includes a second heating element 326 and two waveguide electrodes, and the two waveguide electrodes specifically include a second waveguide electrode 334 and a second waveguide electrode 336. The second waveguide electrode 334 is located on a surface of the P-type doped layer 333, and the second heating element 335 is located on a surface of the second waveguide electrode 334. It should be noted that, the description of positions of the second heating element 335 and the second waveguide electrode 334 in this embodiment is an optional example, and is not limited. For example, the second heating element 335 is located on the surface of the P-type doped layer 333, and the second waveguide electrode 334 is located on a surface of the second heating element 335. In this example, the second heating element 335 has a via, and the second waveguide electrode 334 is connected to the P-type doped layer 333 through the via. In the direction Y, the second waveguide electrode 336 and the N-type doped layer 331 are located on the two surfaces of the substrate 300, and the second waveguide electrode 336 is connected to the N-type doped layer 331 through the substrate 300. The description of a position of the second waveguide electrode 336 in this embodiment is an optional example, and is not limited. For example, the second waveguide electrode 336 is located between the surface of the substrate 300 and the N-type doped layer 331. The tunable laser shown in this embodiment can tune the magnitude of the target wavelength. Specifically, in a heating tuning manner, the second heating element 335 can apply second heat to the second waveguide module 303, and the second waveguide module 303 is configured to tune the target wavelength under action of the second heat. For a specific description, refer to the description of the thermal tuning manner of the first waveguide module 302. Details are not described again. The second waveguide electrode 334 and the second waveguide electrode 336 apply a second reverse bias voltage to the second waveguide module 303. The second reverse bias voltage applies a reverse potential difference to a second PN junction of the second waveguide module 303. The reverse potential difference can exhaust second photogenerated carriers in the second waveguide module 303, thereby reducing a concentration of the second photogenerated carriers in the second waveguide module 303. For a description of a specific process, refer to the description of the process of exhausting the first photogenerated carriers in the first waveguide module 302. Details are not described again.

The tunable laser shown in this embodiment further includes the third waveguide module 304. A position of the third waveguide module 304 is not limited in this embodiment, provided that the third waveguide module 304 is located in the optical resonance cavity of the tunable laser. The third waveguide module 304 is configured to adjust a phase of an optical signal transmitted in the optical resonance cavity, so that a wavelength of an optical signal emitted from the optical resonance cavity is precisely locked to the target wavelength by using the third waveguide module 304. The third waveguide module 304 shown in this embodiment includes an N-type doped region 341 located on the surface of the substrate 300, a waveguide dielectric layer 342 located on a surface of the N-layer doped layer 341, and a P-type doped layer 343 located on a surface of the waveguide dielectric layer 342. Optionally, the tunable laser further includes a third heating element 345 and two third waveguide electrodes. Specifically, the two third waveguide electrodes include a third waveguide electrode 344 and a third waveguide electrode 346. For descriptions of the third heating element 345 and the two third waveguide electrodes, refer to the descriptions of the first heating element 325 and the two first waveguide electrodes. Details are not described again. The third heating element 345 applies third heat to the third waveguide module 304, and the third heat is used to change a refractive index of the third waveguide module 304, thereby precisely tuning the target wavelength. The third waveguide electrode 344 and the third waveguide electrode 346 are configured to apply a third reverse bias voltage to the third waveguide module 304, and the third reverse bias voltage is used to enable the third waveguide module 304 to be in a reverse cut-off state. For a description of the third waveguide module 304 being in the reverse cut-off state to suppress the phase noise, refer to the description of the first waveguide module 302 being in the reverse cut-off state to suppress the phase noise. Details are not described again.

In this embodiment, one or more of the first waveguide module, the second waveguide module, and the third waveguide module are in the reverse cut-off state. A waveguide module in the reverse cut-off state can effectively reduce a concentration of photogenerated carriers of the waveguide module, thereby effectively suppressing phase noise. The following describes beneficial effect of the tunable laser provided in this embodiment.

For example, the tunable laser shown in this embodiment is a DBR laser. The DBR laser has advantages such as high integration, low costs, and a high wavelength switching speed. Phase noise of the DBR laser mainly includes three parts: spontaneous emission noise, external disturbance, and random disturbance noise. The external disturbance is introduced by a circuit of the tunable laser and environmental noise in an environment in which the tunable laser is located. The random disturbance noise is introduced by injected noise and random recombination of carriers.

In an existing solution, to achieve the purpose of tuning a target wavelength, a current may be injected into a waveguide module, and the current injected into the waveguide module can change a refractive index of the waveguide module, thereby tuning the target wavelength. However, the injected current increases a concentration of carriers in the waveguide module, and increases a probability of random recombination of the carriers. As a result, random disturbance noise in phase noise of a laser increases sharply, and a linewidth and phase noise of the DBR laser increase.

However, the tunable laser shown in this embodiment changes the refractive index of the waveguide module in a thermal tuning manner, to change the target wavelength emitted by the tunable laser. Adjusting the refractive index in the thermal tuning manner replaces the existing solution in which the current is injected into the waveguide module to change the refractive index. Because there is no need to inject the current used to change the refractive index, impact of random disturbance noise in the tunable laser on a linewidth is effectively reduced. In addition, the concentration of the carriers in the waveguide module is reduced, noise caused by random recombination of the carriers is suppressed, and the linewidth is effectively reduced, thereby improving bandwidth utilization of the tunable laser.

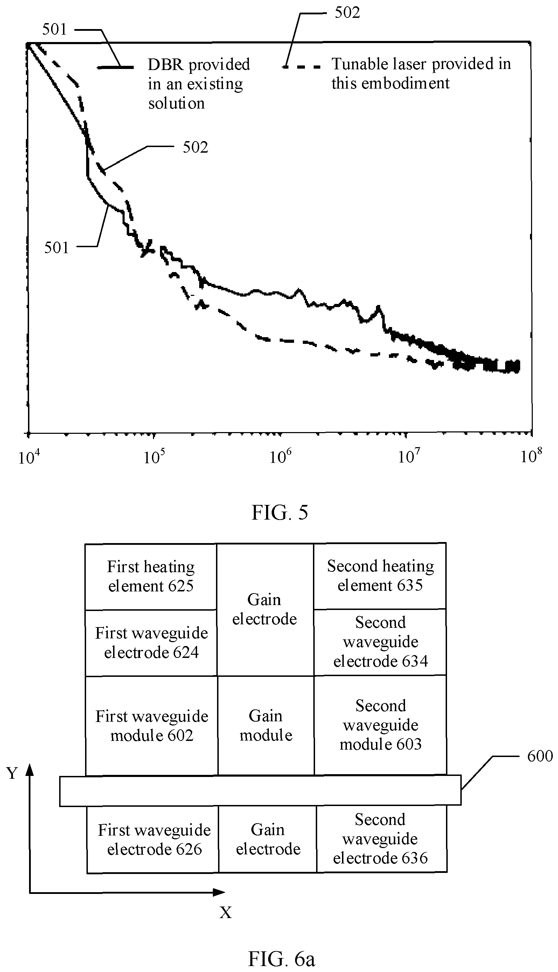

FIG. 5 is an example diagram of comparison between a phase noise curve of a tunable laser and a phase noise curve of an existing DBR laser according to this application. In a coordinate system shown in FIG. 5, a horizontal coordinate is a frequency of noise in a unit of hertz (Hz), and a vertical coordinate is an intensity of phase noise. The phase noise curve shown in FIG. 5 represents a magnitude of phase noise in a unit frequency range, and a unit may be radians per square root hertz (rad/Hz) or degrees per square root hertz (deg/Hz). A phase noise curve 501 shown in FIG. 5 is the phase noise curve of the existing DBR laser, and a phase noise curve 502 is a phase noise curve of the tunable laser provided in this embodiment. With reference to the phase noise curve 501 and the phase noise curve 502, it can be learned that, compared with the phase noise curve 501 of the existing DBR laser, the phase noise curve 502 of the tunable laser in this embodiment is significantly reduced in 1 MHz to 100 MHz. It can be learned that, the tunable laser shown in this embodiment can effectively suppress random disturbance noise by enabling the PN junction of the waveguide module to be in the reverse cut-off state. It may be understood that the tunable laser provided in this embodiment effectively suppresses phase noise in a low frequency band (namely, an MHz frequency band).

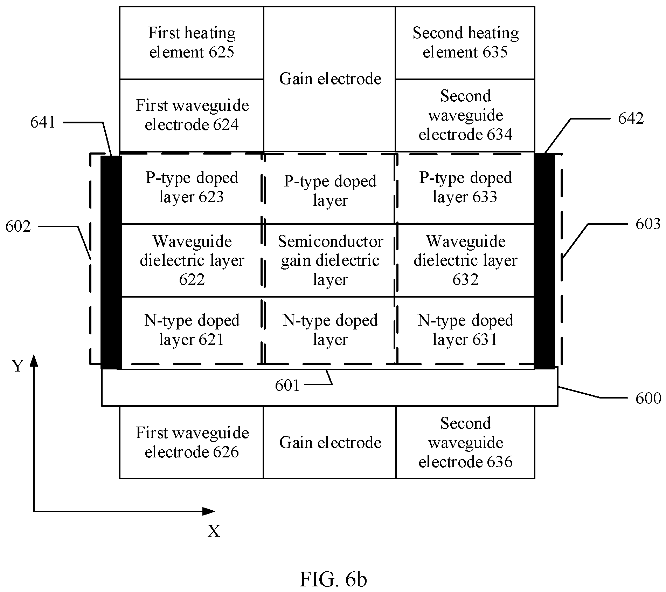

In the foregoing embodiment, for example, the first reflection layer 322 is included inside the first waveguide module 302, and the second reflection layer 332 is included inside the second waveguide module 302, so that an optical resonance cavity is formed between the first reflection layer 322 and the second reflection layer 332. In embodiments shown in FIG. 6a and FIG. 6b, the optical resonance cavity is formed in different manners. FIG. 6a is an example diagram of a structure of a second embodiment of a tunable laser according to this application. FIG. 6b is a side-view example diagram of a structure of an embodiment of the tunable laser shown in FIG. 6a. FIG. 6a and FIG. 6b are side-view example diagrams of the structure of the tunable laser in a plane XY. For a description of the plane XY, refer to the description in FIG. 3. Details are not described again.

The tunable laser includes a substrate 600, and a first waveguide module 602, a gain module 601, and a second waveguide module 603 are sequentially arranged on a surface of the substrate 600 in a direction X. For descriptions of the substrate 600 and the gain module 601 in this embodiment, refer to the descriptions in FIG. 3 and FIG. 4. Details are not described again. The first waveguide module 602 includes an N-type doped layer 621, a waveguide dielectric layer 622, and a P-type doped layer 623. For descriptions of the N-type doped layer 621 and the P-type doped layer 623, refer to the descriptions of the N-type doped layer and the P-type doped layer included in the first waveguide module shown in FIG. 3 and FIG. 4. Details are not described again. The waveguide dielectric layer 622 is located between the N-type doped layer 621 and the P-type doped layer 623. The waveguide dielectric layer 622 is made of a waveguide material and is configured to transmit an optical signal. In the direction X, a surface that faces away from the gain module 601 and that is of the first waveguide module 602 is coated to form a first reflection layer 641. It may be understood that an optical signal emitted by the gain module 601 is transmitted to the first reflection layer 641 through the waveguide dielectric layer 622. In the first waveguide module 602, the waveguide dielectric layer 622 covers at least the waveguide dielectric layer 622. The second waveguide module 603 includes an N-type doped layer 631, a waveguide dielectric layer 632, and a P-type doped layer 633. For descriptions of the N-type doped layer 631 and the P-type doped layer 633, refer to the descriptions of the N-type doped layer and the P-type doped layer included in the second waveguide module shown in FIG. 3 and FIG. 4. Details are not described again. The waveguide dielectric layer 632 is located between the N-type doped layer 631 and the P-type doped layer 633. The waveguide dielectric layer 632 is made of a waveguide material and is configured to transmit an optical signal. In the direction X, a surface that faces away from the gain module 601 and that is of the second waveguide module 603 is coated to form a second reflection layer 642. It may be understood that an optical signal emitted by the gain module 601 is transmitted to the second reflection layer 642 through the waveguide dielectric layer 632. In this embodiment, an optical resonance cavity is formed between the first reflection layer 641 and the second reflection layer 642. For a description of tuning a wavelength of the optical signal by the optical resonance cavity, refer to FIG. 3 and FIG. 4. Details are not described again.

The tunable laser shown in this embodiment includes a first heating element 625 configured to thermally tune the first waveguide module 602 and a second heating element 635 configured to thermally tune the second waveguide module 603. For specific descriptions, refer to the descriptions of the first heating element and the second heating element shown in FIG. 3 and FIG. 4. Details are not described again. The tunable laser shown in this embodiment further includes a first waveguide electrode 624 and a first waveguide electrode 626 that are configured to suppress phase noise of the first waveguide module 602, and a second waveguide electrode 634 and a second waveguide electrode 636 that are configured to suppress phase noise of the second waveguide module 603. For descriptions of the first waveguide electrodes and the second waveguide electrodes, refer to FIG. 3 and FIG. 4. Details are not described again.

In another embodiment, the first reflection layer may be located inside the first waveguide module, as shown in FIG. 3 and FIG. 4, and the second reflection layer may be coated to the surface of the waveguide dielectric layer, as shown in FIG. 6b. For another example, the first reflection layer may be coated to the surface of the waveguide dielectric layer, as shown in FIG. 6b, and the second reflection layer may be located inside the second waveguide module, as shown in FIG. 3 and FIG. 4. This is not specifically limited in this embodiment.

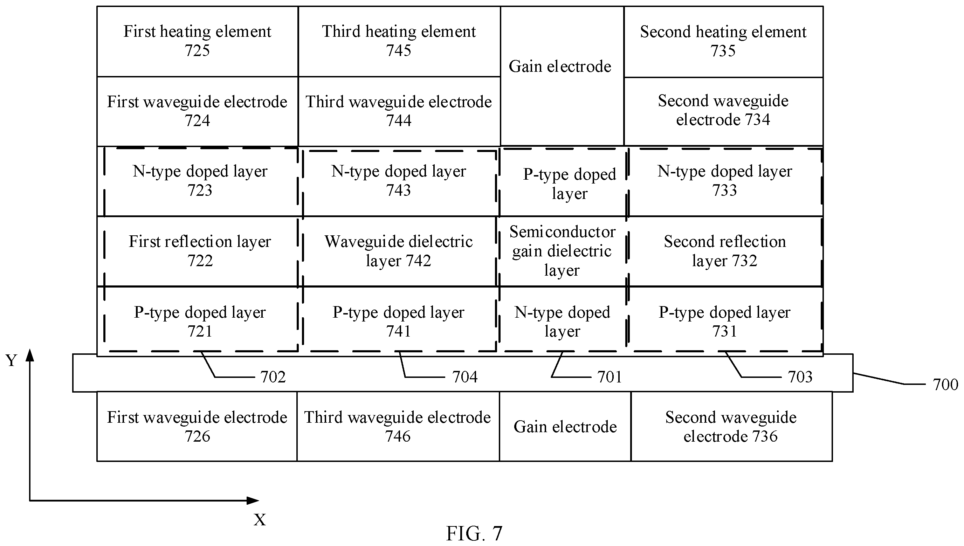

FIG. 7 is a side-view example diagram of a structure of a second embodiment of the tunable laser shown in FIG. 3. FIG. 7 is a side-view example diagram of the structure of the tunable laser in a plane XY. For a description of the plane XY, refer to the description corresponding to FIG. 4. Details are not described again. The tunable laser includes a substrate 700, and a first waveguide module 702, a third waveguide module 704, a gain module 701, and a second waveguide module 703 are sequentially arranged on a surface of the substrate 700 in a direction X. In this embodiment, an example in which the third waveguide module 704 is located between the first waveguide module 702 and the gain module 701 is used. In another example, the third waveguide module 704 may alternatively be located between the gain module 701 and the second waveguide module 703. For descriptions of the substrate 700 and the gain module 701 in this embodiment, refer to the descriptions corresponding to FIG. 3. Details are not described again.

The first waveguide module 702 includes a P-type doped layer 721, a first reflection layer 722, and an N-type doped layer 723 that are sequentially located on the surface of the substrate 700. The tunable laser further includes a first waveguide electrode 724, a first waveguide electrode 326, and a first heating element 725. For descriptions of the P-type doped layer 721, the first reflection layer 722, the N-type doped layer 723, the first waveguide electrode 724, the first waveguide electrode 326, and the first heating element 725, refer to the descriptions corresponding to FIG. 3 and FIG. 4. Details are not described again. A difference between the first waveguide module 702 shown in this embodiment and the first waveguide module 302 shown in FIG. 3 lies in that positions of the P-type doped layer 721 and the N-type doped layer 723 in the first waveguide module are different, so that a first PN junction formed by the P-type doped layer 721 and the N-type doped layer 723 shown in this embodiment is in an NIP structure (a reverse PIN structure). The second waveguide module 703 includes a P-type doped layer 731, a second reflection layer 732, and an N-type doped layer 733 that are sequentially located on the surface of the substrate 700. The tunable laser shown in this embodiment further includes a second waveguide electrode 734, a second waveguide electrode 736, and a second heating element 735. For descriptions of the P-type doped layer 731, the second reflection layer 732, the N-type doped layer 733, the second waveguide electrode 734, the second waveguide electrode 736, and the second heating element 735, refer to the descriptions corresponding to FIG. 3 and FIG. 4. Details are not described again. A difference between the second waveguide module 703 shown in this embodiment and the second waveguide module 303 shown in FIG. 3 lies in that positions of the P-type doped layer 731 and the N-type doped layer 733 in the second waveguide module are different, so that a PN junction formed by the P-type doped layer 731 and the N-type doped layer 733 shown in this embodiment is in an NIP structure.

In this embodiment, the gain module 701 is configured to emit an optical signal. For a description of the gain module 701, refer to the descriptions corresponding to FIG. 3 and FIG. 4. Details are not described again. The optical signal emitted by the gain module 701 enters the first waveguide module 702. When the first waveguide module 702 is excited by the optical signal, a concentration of first photogenerated carriers in the first waveguide 702 is increased. The tunable laser shown in this embodiment can reduce the concentration of the first photogenerated carriers in the first waveguide module 702, thereby effectively reducing a probability of random recombination of the first photogenerated carriers in the first waveguide module 702. This achieves the purpose of suppressing the random recombination of the first photogenerated carriers in the first waveguide module 702, and effectively suppresses phase noise of the first waveguide module 702. To achieve this purpose, the first waveguide electrode 724 and the first waveguide electrode 726 of the tunable laser can apply a first reverse bias voltage to the first waveguide module 702. The first reverse bias voltage applies a reverse potential difference to the first PN junction, and the reverse potential difference can exhaust the first photogenerated carriers in the first waveguide module 702, thereby reducing the concentration of the first photogenerated carriers in the first waveguide module 702. Specifically, when the first photogenerated carriers flow between first PN junctions in the first waveguide module 702, and the first waveguide electrode applies a reverse potential difference to the first PN junctions, the first PN junctions are in a reverse cut-off state, and the first photogenerated carriers are exhausted at the first PN junctions in the reverse cut-off state. Refer to FIG. 7. The first waveguide electrode 724 is connected to the N-type doped layer 723. It can be learned that the first waveguide electrode 724 is connected to a cathode (namely, the N-type doped layer 723) of the first NIP structure. The first waveguide electrode 726 is connected to the P-type doped layer 721. It can be learned that the first waveguide electrode 726 is connected to an anode (namely, the P-type doped layer 721) of the first NIP structure. The first reverse bias voltage enables the NIP structure of the first waveguide module 702 to be in a reverse cut-off state. In this case, the NIP structure enables the first photogenerated carriers in the first waveguide module 702 to flow out of the first waveguide module 702, and the first photogenerated carriers flowing out of the first waveguide module 702 flow to the ground through a ground end of the first waveguide electrode. For a description of suppressing a concentration of second photogenerated carriers in the second waveguide module 703 by the second waveguide electrode 734, refer to the description of suppressing the concentration of the first photogenerated carriers in the first waveguide module 702 by the first waveguide electrode 724. Details are not described again.

The tunable laser shown in this embodiment may further include the third waveguide module 704. A position of the third waveguide module 704 is not limited in this embodiment, provided that the third waveguide module 704 is located in an optical resonance cavity of the tunable laser. The third waveguide module 704 is configured to adjust a phase of an optical signal transmitted in the optical resonance cavity, so that a wavelength of an optical signal emitted from the optical resonance cavity is precisely locked to a target wavelength by using the third waveguide module 704. The third waveguide module 704 shown in this embodiment includes a P-type doped region 741, a waveguide dielectric layer 742, and an N-type doped layer 743 that are sequentially located on the surface of the substrate 700. For specific descriptions, refer to the descriptions of the third waveguide module shown in FIG. 3 and FIG. 4. Details are not described again. The tunable laser may further include a third waveguide electrode 744, a third waveguide electrode 746, and a third heating element 745. For descriptions of the third waveguide electrode 744, the third waveguide electrode 746, and the third heating element 745, refer to the descriptions corresponding to FIG. 3 and FIG. 4. Details are not described again. The third heating element 745 applies third heat to the third waveguide module 704, and the third heat is used to change a refractive index of the third waveguide module 704, thereby precisely tuning the target wavelength. The third waveguide electrode is configured to apply a third reverse bias voltage to the third waveguide module 304, and the third reverse bias voltage is used to enable the third waveguide module 304 to be in a reverse cut-off state.

For positions of the first reflection layer 722 and the second reflection layer 732 shown in this embodiment, refer to FIG. 6b. Details are not described again.

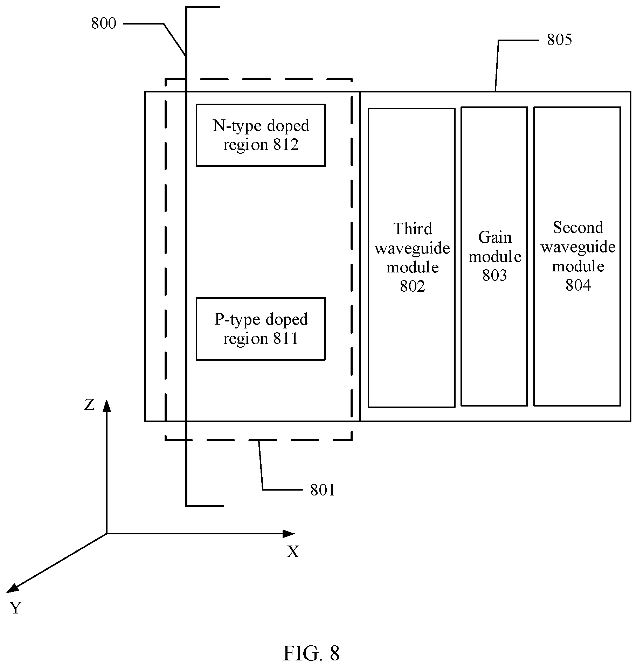

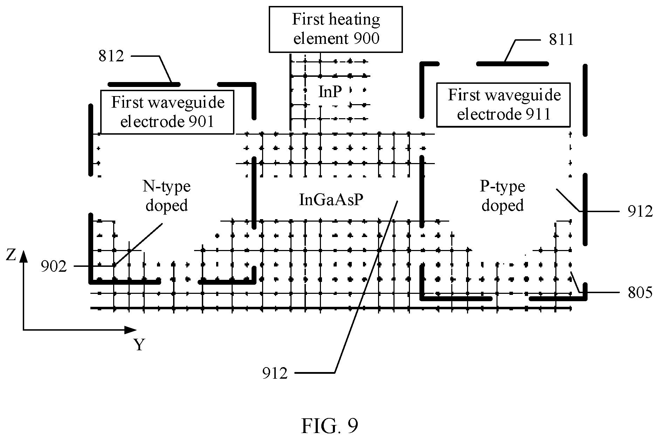

In the foregoing embodiment, the first PN junction is used as an example, and the first PN junction is located inside the first waveguide module. However, in an embodiment shown in FIG. 8, the first PN junction is located on a surface of the first waveguide module. FIG. 8 is an example diagram of a structure of a second embodiment of a tunable laser according to this application. The tunable laser includes a substrate 805, and a first waveguide module 801, a third waveguide module 802, a gain module 803, and a second waveguide module 804 are sequentially arranged on a surface of the substrate 805 in a direction X. For a description of the direction X, refer to the descriptions corresponding to FIG. 3 and FIG. 4. Details are not described again. In this embodiment, an example in which the third waveguide module 802 is located between the first waveguide module 801 and the gain module 803 is used. In another example, the third waveguide module 802 may alternatively be located between the gain module 803 and the second waveguide module 804. In this embodiment, an example in which the substrate 805 is an InP substrate is used. The tunable laser is cut by using a cross section 800 to obtain a cross-sectional example diagram shown in FIG. 9, where FIG. 9 is a cross-sectional example diagram of the structure of the tunable laser shown in FIG. 8. The cross section shown in this embodiment is parallel to a plane YZ, and a direction Z is perpendicular to a plane XY. For a description of the plane XY, refer to the descriptions corresponding to FIG. 3 and FIG. 4. Details are not described again. It may be understood that FIG. 9 is a cross-sectional example diagram of the first waveguide module 801 in the plane YZ. The first waveguide module 801 shown in this embodiment includes a first reflection layer 912. For a description of the first reflection layer 912, refer to the descriptions corresponding to FIG. 3 and FIG. 4. Details are not described again. The first waveguide module 801 specifically includes a P-type doped region 811 and an N-type doped region 812. Specifically, the P-type doped region 811 specifically includes a P-type doped layer 912 deposited on a surface of the first waveguide module 801 and a first waveguide electrode 911 located on a surface of the P-type doped layer 912. For a description of a position of another first waveguide electrode that is used to form a circuit loop and that is included in the tunable laser shown in this embodiment, refer to the descriptions corresponding to FIG. 3 and FIG. 4. Details are not described again. The N-type doped region 812 specifically includes an N-type doped layer 902 deposited on the surface of the first waveguide module 801 and a first waveguide electrode 901 located on a surface of the N-type doped layer. The P-type doped layer 912 and the N-type doped layer 902 shown in this embodiment form a first PN junction. For a description of the first PN junction, refer to the descriptions corresponding to FIG. 3 and FIG. 4. Details are not described again. In this embodiment, a surface of an InP substrate of the first waveguide module is further connected to a first heating element 900, and the heating element 900 is configured to provide first heat for the first PN junction. For a description of providing the first heat for the first PN junction, refer to the descriptions corresponding to FIG. 3 and FIG. 4. Details are not described again.

In this embodiment, an optical signal emitted by the gain module 803 enters the first waveguide module 801. When the first waveguide module 801 is excited by the optical signal, first photogenerated carriers are generated. The tunable laser shown in this embodiment can reduce a concentration of the first photogenerated carriers in the first waveguide module 801, thereby effectively reducing a probability of random recombination of the first photogenerated carriers in the first waveguide module 801. This achieves the purpose of suppressing the random recombination of the first photogenerated carriers in the first waveguide module 801, and effectively suppresses phase noise of the first waveguide module 801. To achieve this purpose, the two first waveguide electrodes included in the first waveguide module can apply a first reverse bias voltage to the first waveguide module 801. The first reverse bias voltage applies a reverse potential difference to the first PN junction, and the reverse potential difference can exhaust the first photogenerated carriers in the first waveguide module 801, thereby reducing the concentration of the first photogenerated carriers in the first waveguide module 801. For a description of the first reverse bias voltage, refer to the descriptions corresponding to FIG. 3 and FIG. 4. Details are not described again. The second waveguide module 804 shown in this embodiment may also include a P-type doped region and an N-type doped region, and the third waveguide module 802 may also include a P-type doped region and an N-type doped region. For descriptions of the P-type doped regions and the N-type doped regions, refer to the descriptions of the P-type doped region and the N-type doped region included in the first waveguide module 801. Details are not described again.

In the foregoing embodiment, an example in which the first waveguide module is used to form an optical resonance cavity is used. In another example, the first waveguide module may alternatively be located in an optical resonance cavity. For example, the tunable laser includes the first waveguide module, a fourth waveguide module, and a fifth waveguide module. The fourth waveguide module and the fifth waveguide module are configured to form the optical resonance cavity. For descriptions of structures of the fourth waveguide module and the fifth waveguide module, refer to the descriptions corresponding to FIG. 3, FIG. 4, FIG. 6a, and FIG. 6b. Details are not described again. The first waveguide module is located in the optical resonance cavity formed by the fourth waveguide module and the fifth waveguide module. For a description of a structure of the first waveguide module, refer to the descriptions of the third waveguide module shown in FIG. 3 and FIG. 4. Details are not described again.

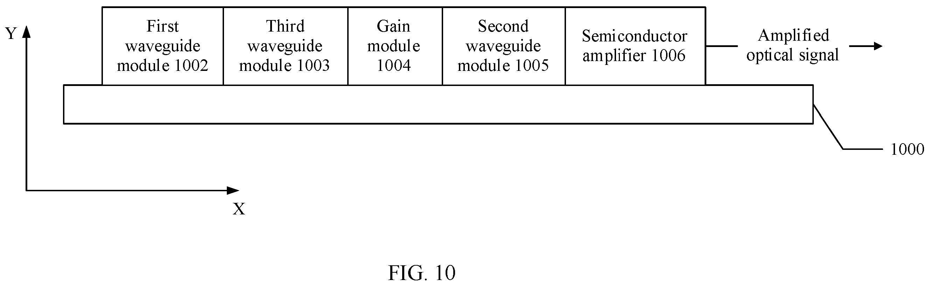

FIG. 10 is an example diagram of a structure of a third embodiment of a tunable laser according to this application. Specifically, FIG. 10 is an example diagram of a structure of the tunable laser in a plane XY. For a description of the plane XY, refer to the description corresponding to FIG. 3. Details are not described again. The tunable laser shown in this embodiment includes a substrate 1000. In a direction X, a surface of the substrate 1000 sequentially includes a first waveguide module 1002, a third waveguide module 1003, a gain module 1004, a second waveguide module 1005, and a semiconductor amplifier (semiconductor optical amplifier, SOA) 1006. For descriptions of the first waveguide module 1002, the third waveguide module 1003, the gain module 1004, and the second waveguide module 1005 shown in this embodiment, refer to FIG. 3, FIG. 4, FIG. 6a, FIG. 6b, FIG. 7, FIG. 8, and FIG. 9. Details are not described again. In this embodiment, a tuned optical signal emitted from the second waveguide module 1005 is transmitted to the SOA 1006, and the SOA 1006 is configured to amplify power of the tuned optical signal, to output an amplified optical signal. In this embodiment, an example in which the first waveguide module 1002, the third waveguide module 1003, the gain module 1004, the second waveguide module 1005, and the SOA 1006 are located on the same substrate 1000 is used.

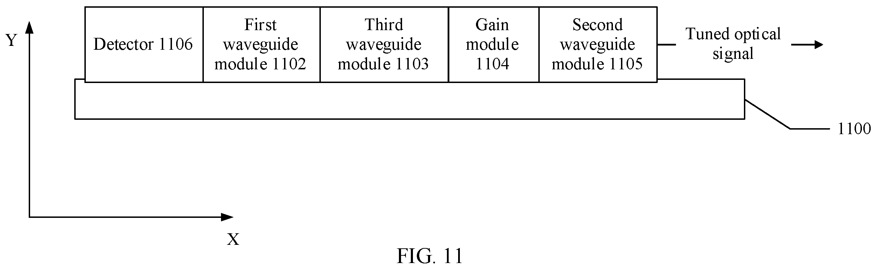

FIG. 11 is an example diagram of a structure of a fourth embodiment of a tunable laser according to this application. Specifically, FIG. 11 is an example diagram of a structure of the tunable laser in a plane XY. For a description of the plane XY, refer to the description corresponding to FIG. 3. Details are not described again. The tunable laser shown in this embodiment includes a substrate 1100. In a direction X, a surface of the substrate 1100 sequentially includes a detector 1106, a first waveguide module 1102, a third waveguide module 1103, a gain module 1104, and a second waveguide module 1105. For descriptions of the first waveguide module 1102, the third waveguide module 1103, the gain module 1104, and the second waveguide module 1105 shown in this embodiment, refer to FIG. 3, FIG. 4, FIG. 6a, FIG. 6b, FIG. 7, FIG. 8, and FIG. 9. Details are not described again. In this embodiment, the second waveguide module 1105 emits a tuned optical signal. The detector 1106 may be a photodiode (positive intrinsic-negative, PIN) or an avalanche photodiode (avalanche photodiode, APD). The detector 1106 is configured to: receive an optical signal transmitted from the first waveguide module 1102, and perform optical-to-electrical conversion on the optical signal to obtain a detection electrical signal. The detector 1106 can detect performance of the tunable laser based on the detection electrical signal, for example, detect a wavelength, optical power, a linewidth, and fault detection of a tuned optical signal. A specific detection type is not limited. In this embodiment, an example in which the first waveguide module 1102, the third waveguide module 1103, the gain module 1104, the second waveguide module 1105, and the detector 1106 are located on the same substrate 1100 is used.

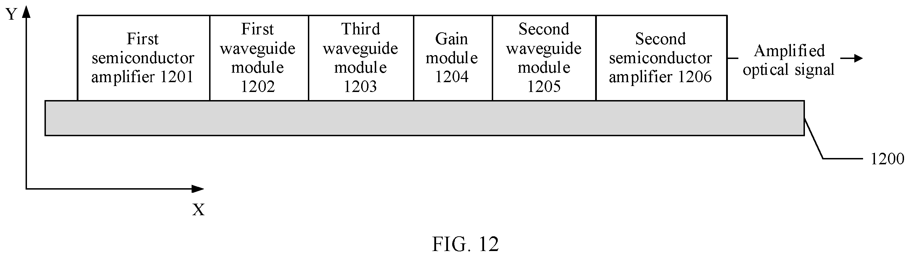

FIG. 12 is an example diagram of a structure of a fifth embodiment of a tunable laser according to this application. FIG. 12 is an example diagram of a structure of the tunable laser in a plane XY. For a description of the plane XY, refer to the description corresponding to FIG. 3. Details are not described again. The tunable laser shown in this embodiment includes a substrate 1200. In a direction X, a surface of the substrate 1200 sequentially includes a first SOA 1201, a first waveguide module 1202, a third waveguide module 1203, a gain module 1204, a second waveguide module 1205, and a second SOA 1206. For descriptions of the first waveguide module 1202, the third waveguide module 1203, the gain module 1204, the second waveguide module 1205, and the second SOA 1206 shown in this embodiment, refer to the descriptions corresponding to FIG. 10. Details are not described again. The first SOA 1201 is configured to: receive an optical signal transmitted from the first waveguide module 1202, and amplify power of the optical signal, so that performance of the tunable laser is detected based on the amplified optical signal. For a description of the first SOA 1201, refer to the description of the second SOA. Details are not described again. In this embodiment, an example in which the first SOA 1201, the first waveguide module 1202, the third waveguide module 1203, the gain module 1204, the second waveguide module 1205, and the second SOA 1206 are located on the same substrate 1200 is used.

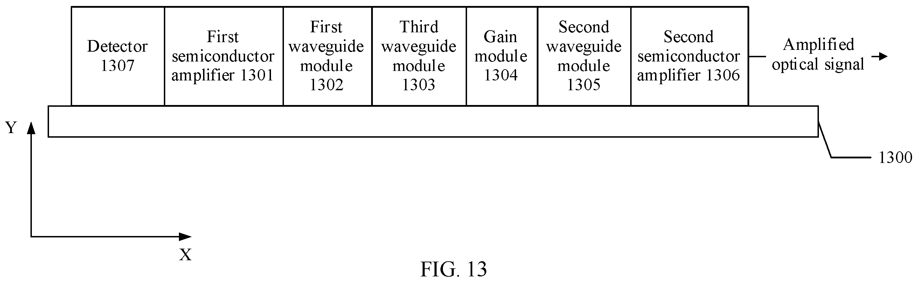

FIG. 13 is an example diagram of a structure of a sixth embodiment of a tunable laser according to this application. FIG. 13 is an example diagram of a structure of the tunable laser in a plane XY. For a description of the plane XY, refer to the description corresponding to FIG. 3. Details are not described again. The tunable laser shown in this embodiment includes a substrate 1300. In a direction X, a surface of the substrate 1300 sequentially includes a detector 1307, a first SOA 1301, a first waveguide module 1302, a third waveguide module 1303, a gain module 1304, a second waveguide module 1305, and a second SOA 1306. For a description of the detector 1307 shown in this embodiment, refer to the description corresponding to FIG. 11. For descriptions of the first SOA 1301, the first waveguide module 1302, the third waveguide module 1303, the gain module 1304, the second waveguide module 1305, and the second SOA 1306, refer to the descriptions corresponding to FIG. 12. Details are not described again. In this embodiment, an example in which the detector 1307, the first SOA 1301, the first waveguide module 1302, the third waveguide module 1303, the gain module 1304, the second waveguide module 1305, and the second SOA 1306 are located on the same substrate 1300 is used.

An embodiment of this application provides a photoelectric conversion module. The photoelectric conversion module includes the tunable laser shown in the foregoing embodiment. For a description of a structure of the photoelectric conversion module, refer to FIG. 2a and FIG. 2b. Details are not described again. A packaging form of the photoelectric conversion module is not limited in this embodiment. For example, the packaging form of the photoelectric conversion module may be an optical transceiver board (optical transceiver board, OTB), near package optics (near package optics, NPO), or on board optics (on board optics, OBO) based on an optical input&output (optical input&output, OIO) technology. A specific type is not limited.

An embodiment of this application further provides a communication system. For a description of a structure of the communication system, refer to FIG. 1, FIG. 2a, and FIG. 2b. Details are not described again.

An embodiment of this application further provides an optical network. The optical network includes a first communication system and a second communication system. For a description of a structure of the optical network, refer to FIG. 1. Details are not described again.

The foregoing embodiments are merely intended for describing the technical solutions of this application other than limiting this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the spirit and scope of the technical solutions of embodiments of this application.

## Claims

1. A tunable laser, comprising a gain module, a first waveguide module, a gain electrode, a first waveguide electrode, and a first heating element, wherein the gain module is connected to the gain electrode, the first waveguide electrode and the first heating element are separately connected to the first waveguide module, and the first waveguide module comprises a first PN junction; and
the gain electrode is configured to apply a current to the gain module, the gain module is configured to emit an optical signal based on the current, the first heating element is configured to apply first heat to the first waveguide module, and the first waveguide module is configured to tune a wavelength of the optical signal under action of the first heat, so that the tunable laser emits an optical signal tuned by the first waveguide module; and the first waveguide electrode is configured to apply a first reverse bias voltage to the first PN junction, and the first reverse bias voltage is used to enable the first PN junction to be in a reverse cut-off state.

2. The tunable laser according to claim 1, wherein the tunable laser further comprises a second waveguide module, the first waveguide module and the second waveguide module form an optical resonance cavity used to tune the wavelength of the optical signal, and the gain module is located in the optical resonance cavity.

3. The tunable laser according to claim 2, wherein the tunable laser further comprises a second heating element, and the second heating element is connected to the second waveguide module; and
the second heating element is configured to apply second heat to the second waveguide module, and the second waveguide module is configured to tune the wavelength of the optical signal under action of the second heat.

4. The tunable laser according to claim 2 or 3, wherein the tunable laser further comprises a second waveguide electrode, the second waveguide electrode is connected to the second waveguide module, and the second waveguide module comprises a second PN junction; and
the second waveguide electrode is configured to apply a second reverse bias voltage to the second PN junction, and the second reverse bias voltage is used to enable the second PN junction to be in a reverse cut-off state.

5. The tunable laser according to any one of claims 2 to 4, wherein the tunable laser further comprises a third waveguide module and a third heating element, the third heating element is connected to the third waveguide module, and the third waveguide module is located in the optical resonance cavity; and
the third heating element is configured to apply third heat to the third waveguide module, and the third waveguide module is configured to tune the wavelength of the optical signal under action of the third heat.

6. The tunable laser according to claim 5, wherein the tunable laser further comprises a third waveguide electrode, the third waveguide electrode is connected to the third waveguide module, and the third waveguide module comprises a third PN junction; and
the third waveguide electrode is configured to apply a third reverse bias voltage to the third PN junction, and the third reverse bias voltage is used to enable the third PN junction to be in a reverse cut-off state.

7. The tunable laser according to claim 1, wherein the tunable laser comprises a fourth waveguide module and a fifth waveguide module, the fourth waveguide module and the fifth waveguide module form an optical resonance cavity used to tune the wavelength of the optical signal, and the gain module and the first waveguide module are located in the optical resonance cavity.

8. The tunable laser according to any one of claims 1 to 7, wherein the first PN junction is located inside the first waveguide module, or the first PN junction is located on a surface of the first waveguide module.

9. The tunable laser according to any one of claims 1 to 8, wherein the first waveguide electrode is located between the first waveguide module and the first heating element, or the first heating element is located between the first waveguide electrode and the first waveguide module, the first heating element has a via, and the first waveguide electrode is connected to the first waveguide module through the via.

10. A photoelectric conversion module, comprising a modulator, an output optical fiber, and the tunable laser according to any one of claims 1 to 9, wherein the modulator is separately connected to the tunable laser and the output optical fiber;
the modulator is configured to: receive a first service electrical signal, and receive the tuned optical signal from the tunable laser; and
the modulator is further configured to: modulate the first service electrical signal onto the tuned optical signal to obtain a first service optical signal, and emit the first service optical signal through the output optical fiber.

11. A photoelectric conversion module, comprising a demodulator, an input optical fiber, and the tunable laser according to any one of claims 1 to 9, wherein the demodulator is separately connected to the tunable laser and the input optical fiber;
the demodulator is configured to: receive a second service optical signal from the input optical fiber, and receive the tuned optical signal from the tunable laser; and
the demodulator is further configured to perform coherent demodulation on the second service optical signal based on the tuned optical signal to obtain a second service electrical signal.

12. A communication system, comprising a device and the photoelectric conversion module according to claim 10, wherein the device comprises a processing chip and a connector, the processing chip is connected to the photoelectric conversion module via the connector, and the processing chip is configured to send the first service electrical signal to the photoelectric conversion module.

13. A communication system, comprising a device and the photoelectric conversion module according to claim 11, wherein the device comprises a processing chip and a connector, the processing chip is connected to the photoelectric conversion module via the connector, and the processing chip is configured to receive the second service electrical signal from the photoelectric conversion module.
